# EUROPEAN PATENT SPECIFICATION

(11) **EP 1 760 133 B1**
(45) Date of publication and mention of the grant of the patent: **28.09.2011**
(21) Application number: 05741407.0
(22) Date of filing: 19.05.2005
(51) Int. Cl.: C09J 167/06, C09J 7/00, C09J 9/02, H01R 11/01, H05K 3/32, H05K 3/34, C09J 167/07, C08F 283/01, C09J 7/02

(54) **ADHESIVE AGENT COMPOSITION AND ADHESIVE FILM FOR ELECTRONIC COMPONENT**
KLEBMITTELZUSAMMENSETZUNG UND KLEBFILM FÜR ELEKTRONISCHES BAUELEMENT
COMPOSITION D'AGENT ADHÉSIF ET PELLICULE ADHÉSIVE POUR COMPOSANT ÉLECTRONIQUE

(30) Priority: 19.05.2004 JP 2004149372; 13.12.2004 JP 2004360078; 13.12.2004 JP 2004360079
(43) Date of publication of application: 07.03.2007
(73) Proprietor: Bridgestone Corporation, Tokyo 104-8340 (JP)
(72) Inventor: MATSUSE, Takahiro, c/o Technical Center, Kodaira-shi, Tokyo 187-0031 (JP); HANZAWA, Kentaro, c/o Technical Center, Kodaira-shi, Tokyo 187-0031 (JP)
(74) Representative: Whalley, Kevin
(86) International application number: PCT/JP2005/009136
(87) International publication number: WO 2005/111168

(56) References cited:
- JP-A- 1 213 325
- JP-A- 3 160 077
- JP-A- 10 338 860
- JP-A- 63 168 478
- JP-A- 2000 017 235
- JP-A- 2001 297 631
- JP-A- 2002 241 722
- JP-A- 2003 268 052
- JP-A- 2003 277 694
- US-A- 4 477 636

## Description

### Technical Field

The present invention relates to an adhesive agent composition used for bonding an electronic component, and an adhesive film produced by forming the adhesive agent composition into a film.

### Background Art

An ACF (Anisotropic Conductive Film) is used to bond various kinds of circuit boards to each other while ensuring electrical conduction between circuits, for example, when a flexible printed circuit (FPC) board or a TAB chip is connected to ITO (Indium Tin Oxide) terminals formed on a glass substrate of a liquid crystal panel.

Japanese Unexamined Patent Application Publication No. 2003-20464 and No. 2001-202831 disclose ACFs in which conductive particles are dispersed in a thermo- or photosetting adhesive agent containing a polyester unsaturated compound as a main ingredient.

The conductive particles mixed in the ACFs are made of metal particles or plastic particles plated with a metal, and they are expensive.

An NCF (Non Conductive Film) containing no conductive particles is also used. However, the known NCF exhibits insufficient flowability when it is heated and softened.
Adhesive compositions are also known from US4477636, JP63-168478 and JP 2000-17235.

### Summary of the Invention

According to first and second aspects, an object of the present invention is to provide an adhesive agent composition and an adhesive film, which have superior adhesivity and flowability.

The adhesive agent composition for an electronic component, according to the first aspect, contains a thermosetting compound and used for bonding said electronic component, wherein said thermosetting compound is a polyester unsaturated compound having a number average molecular weight of 2,000 - 6,000; said polyester unsaturated compound is a compound obtained by introducing an acryloxy group and/or a methacryloxy group into saturated copolymer polyester; and further containing 0.1 - 10 weight parts of an organic peroxide with respect to 100 weight parts of said thermosetting compound.

The adhesive film according to the second aspect is produced by forming the adhesive agent composition according to the first aspect into a film.
A further object
of the present invention is to provide an adhesive agent composition and an adhesive film, which ensures superior durability of an adhesion force against heat and against wet heat, and which can maintain a high adhesion force for a long period even under high-temperature or high-temperature and high-humidity environments.

The adhesive agent composition for bonding the electronic component, according to the invention preferably contains, in addition to a thermosetting resin, a multifunctional glycidyl monomer.

### Detailed Description of Preferred Embodiments

[Preferred Embodiments of First and Second Aspects]
The adhesive agent composition according to the first aspect contains a polyester unsaturated compound having a number average molecular weight of 2,000 - 6,000.

The low-molecular-weight polyester unsaturated compound having a number average molecular weight of 2,000 - 6,000 gives good flowability to a film. A thermosetting adhesive agent containing such a polyester unsaturated compound as a main ingredient has advantages given below.
1) It has superior resistance against heat and moisture and effectively exhibits ACF characteristics even after being held under high temperature and high humidity for a long time. Thus, its durability is excellent.
2) It has good repairability.
3) As compared with known adhesive agents, it exhibits higher adhesivity with stability. In particular, it exhibits high adhesivity with respect to polyimide on a non-electrode surface of a 2-layered flexible printed circuit board of non-adhesive type for which the known adhesive agents have a difficulty in bonding thereto.
4) While known epoxy adhesive agents require heating to 150° or above, an ACF using the adhesive agent according to the first aspect enables hardening and bonding to be made 130°C or below, particularly 100°C or below.
5) Stickiness of the known epoxy- or phenol-based ACFs is so weak that temporary fixing of the films to an electrode is difficult to achieve with tack strength and the films are apt to peel off, thus resulting in poor workability. In contrast, the ACF using the adhesive agent according to the first aspect can provide a high adhesive force for temporary fixing of the film and ensure good workability.

The adhesive film according to the second aspect, which is produced by forming the adhesive agent composition according to first aspect into a film, has superior adhesivity and flowability. The adhesive film is able to sufficiently flow between complicated and fine bumps to such an extent as establishing connection and conduction between circuits with sufficient reliability. Further, the adhesive film is able to firmly bond circuit boards to each other.

The polyester unsaturated compound is a compound obtained by introducing a (metha)acryloxy group into saturated copolymer polyester that is preferably dissolved in a solvent. The (metha)acryloxy group is an acryloxy group and/or a metha-acryloxy group.

The polyester unsaturated compound is preferably dissoluble in an organic solvent, such as acetone, MEK, ethyl acetate, cellosolve acetate, dioxane, THF, benzene, toluene, xylene, cyclohexane, and Solvesso 100.

The saturated copolymer polyester dissoluble in the solvent is preferably obtained by copolymerization of acid and alcohol. The acid preferably contains a terephthalic acid as a main ingredient. Further, the acid preferably contains a phthalic acid, an isophthalic acid, an adipic acid, a sebacic acid, a dodecane acid, etc. in amount of 5 - 50 mol% with respect to the total acid. The alcohol preferably contains ethylene glycol and/or 1,4-butanediol. Further, the alcohol preferably contains at least one kind of 1,3-propanediol, 2,2-dimethyl-1,3-propanediol, 2,2-diethyl-1,3-propanediol, 2-ethyl-2-butyl-1,3-propanediol, 1,6-hexanediol, 1,9-nonanediol, etc. in amount of 5 - 50 mol% with respect to the total alcohol.

The (metha)acryloxy group is preferably introduced into the saturated copolymer polyester by the following method (1), (2) or (3).
(1) A method of reacting isocyanatealkyl(metha)acrylate with a hydroxyl group of the saturated copolymer polyester.
(2) A method of utilizing an ester interchange reaction between alkyl(metha)acrylate and a hydroxyl group of the saturated copolymer polyester.
(3) A method of reacting isocyanatealkyl(metha)acrylate, which is obtained by a reaction between a diisocyanate compound and hydroxyalkyl(metha)acrylate, with a hydroxyl group of the saturated copolymer polyester.

The polyester unsaturated compound has a number average molecular weight of 2,000 - 6,000, preferably 3,000 - 5,000. A compound having a number average molecular weight of larger than 6,000 does not provide sufficient flowability, whereas a compound having a number average molecular weight of smaller than 2,000 does not provide sufficient adhesivity.

The polyester unsaturated compound obtained by introducing the (metha)acryloxy group into the saturated copolymer polyester is preferably produced by introducing the (metha)acryloxy group into the saturated copolymer polyester having a number average molecular weight of about 2,000 - 6,000.

The polyester unsaturated compound having the number average molecular weight within the above-mentioned range and the polyester unsaturated compound having the number average molecular weight outside the above-mentioned range may be blended with each other.

For the purpose of increasing durability against heat and against wet heat, the adhesive agent composition may contain a multifunctional glycidyl monomer. The multifunctional glycidyl monomer is a monomer compound having two or more glycidyl groups in a molecule in average.

The compound having two glycidyl groups in a molecule in average may be, for example, polyethyleneglycol diglycidyl ether, polypropyleneglycol-diglycidyl ether, tetramethyleneglycol·diglycidyl ether, 1,6-hexamethyleneglycol·diglycidyl ether, neopentylglycol· diglycidyl ether, or glycerin·diglycidyl ether, which belong to the aliphatic series; hydrogenated bisphenol A·diglycidyl ether, hydrogenated isophthalic acid diglycidyl ester, 3,4-epoxy·cyclohexyl·methyl-3,4-epoxy·cyclohexane·carboxylate, or bis(3,4-epoxy·cyclohexyl)adipate, which belong to the alicyclic series; or diglycidyl·hydantoin, diglycidyl· oxyalkyl·hydantoin, which belong to the heterocyclic series; or bisphenol A·diglycidyl ether, an initial condensation product of bisphenol A·diglycidyl ether, diphenylmethane diglycidyl ether, terephthalic acid diglycidyl ester, isophthalic acid diglycidyl ester, or diglycidyl·aniline, which belong to the aromatic series.

The compound having three glycidyl groups in a molecule in average may be, for example, trimethylolpropane· triglycidyl ether which belongs to the aliphatic series; triglycidyl isocyanurate, triglycidyl cyanurate, or triglycidyl·hydantoin, which belong to the heterocyclic series; or triglycidyl-para- or meta-aminophenol which belongs to the aromatic series.

The compound having four glycidyl groups in a molecule in average may be, for example, tetraglycidyl· benzylethane, sorbitol·tetraglycidyl ether, tetraglycidyl· diaminophenylmethane, or tetraglycidyl· bisaminomethylcyclohexane.

The multifunctional glycidyl monomer is preferably at least one kind of multifunctional glycidyl ether compound. It may be, for example, ethyleneglycol·diglycidyl ether or trimethylolpropane·triglycidyl ether. Most preferably, it is trimethylolpropane·triglycidyl ether.

The amount of the mixed multifunctional glycidyl monomer is preferably 0.1 - 20 weight parts, more preferably 1 - 10 weight parts, with respect to 100 weight parts of the polyester unsaturated compound.

The adhesive film containing, as a main ingredient, the low-molecular-weight polyester unsaturated compound having a number average molecular weight of 2,000 - 6,000 and also containing the multifunctional glycidyl monomer maintains a high adhesion force for a long period even under conditions requiring resistance against heat and resistance against wet heat.

The detailed action mechanism which provides the effect of increasing the durability of a adhesive force against heat and against wet heat with mixing of the multifunctional glycidyl monomer is not clarified. It is however deemed that the durability of a layer of the thermosetting adhesive agent against heat and against wet heat is increased by creation of chemical bonding based on an addition reaction between a glycydyl group and an amide group, or an insertion reaction between them, or both of those reactions.

At least one kind of reactive compound (monomer) having an acryloxy group, a methacryloxy group, or an epoxy group is preferably mixed in the adhesive agent composition for the purpose of improving or adjusting physical properties (such as mechanical strength, adhesivity, optical characteristics, heat resistance, moisture resistance, weatherability, and cross-linking rate) of the adhesive film. The reactive compound may be a derivative of an acrylic acid or a methacrylic acid, e.g., any of esters and amides thereof. The ester residue may be, for example, not only an alkyl group such as a methyl, ethyl, dodecyl, stearyl, or layryl group, but also a cyclohexyl group, a tetrahydrofurfuryl group, an aminoethyl group, a 2-hydroxyethyl group, a 3-hydroxypropyl group, or a 3-chloro-2-hydroxypropyl group. The reactive compound may be ester in combination with a multifunctional alcohol, such as ethylene glycol, triethylene glycol, polypropylene glycol, polyethylene glycol, trimethylol propane, or pentaerythritol. The amide may be diacetone acrylamide.

A multifunctional cross-linking aid may be ester of an acrylic acid or a methacrylic acid, such as trimethylol propane, pentaerythritol, or glycerine. The compound containing the epoxy group may be triglycidyl tris(2-hydroxyethyl)isocyanurate, neopentyl glycol diglycidyl ether, 1,6-hexandiol diglycidyl ether, allyl glycidyl ether, 2-ethylhexyl glycidyl ether, phenyl glycidyl ether, phenol(EO)₅ glycidyl ether, p-t-butylphenyl glycidyl ether, adipic acid diglycidyl ester, phthalic acid diglycidyl ester, glycidyl methacrylate, or butyl glycidyl ether. The compound containing the epoxy group may be a polymer alloy containing the epoxy group.

The reactive compound is added in amount of preferably 0.5 - 80 weight parts, more preferably 0.5 - 70 weight parts, with respect to 100 weight parts of the polyester unsaturated compound. If the mixed amount exceeds 80 weight parts, workability and film formation performance in the stage of preparing the adhesive agent may be reduced.

The adhesive agent composition contains an organic peroxide as a hardener. The organic peroxide is preferably decomposed at temperature of 70°C or above to generate a radical. More preferably, the decomposition temperature of the organic peroxide at a half-life of 10 hours is 50° or above.

The organic peroxide may be at least one kind of 2,5-dimethylhexane-2,5-dihydroperoxide, 2,5-dimethyl-2,5-di(t-butylperoxy)hexine3, di-t-butylperoxide, t-butylcumylperoxide, 2,5-dimethyl-2,5-di(t-butylperoxy)hexane, dicumylperoxide, α,α'-bis(t-butylperoxyisopropyl)benzene, n-butyl-4,4'-bis(t-butylperoxy)valerate, 1,1-bis(t-butylperoxy)cyclohexane, 1,1-bis(t-butylperoxy)-3,3,5-trimethylcyclohexane, t-butyl peroxybenzoate, benzoyl peroxide, t-butylperoxy acetate, methyl ethyl ketone peroxide, 2,5-dimethylhexyl-2,5-bisperoxybenzoate, butyl hydroperoxide, p-menthane hydroperoxide, p-chlorobenzoyl peroxide, hydroxyheptyl peroxide, chlorohexanone peroxide, octanoyl peroxide, decanoyl peroxide, rauloyl peroxide, cumylperoxyoctoate, succinic acid peroxide, acetyl peroxide, t-butylperoxy(2-ethylhexanoate), m-toluoyl peroxide, t-butylperoxyisobutylate, and 2,4-dichlorobenzoyl peroxide.

The organic peroxide is mixed in amount of 0.1 - 10 weight parts with respect to 100 weight parts of the polyester unsaturated compound.

By controlling the amount of the mixed organic peroxide, the reaction start temperature (hardening start temperature) of the composition can be controlled. For example, by reducing the amount of the mixed organic peroxide in the adhesive film, the reaction start temperature of the composition can be delayed in reaching a predetermined level, and flowability of the composition at the start of the reaction can be improved eventually.

The adhesive agent composition may contain a silane coupling agent as an adhesion accelerator. The silane coupling agent may be at least one kind of vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl) ethyltrimethoxysilane, vinyltrichlorosilane, γ-mercaptopropyltrimethoxysilane, γ-aminopropyltriethoxysilane, and N-β-(aminoethyl)-γ-aminopropyltrimethoxysilane.

The amount of the added silane coupling agent is preferably 0.01 - 5 weight parts with respect to 100 weight parts of the polyester unsaturated compound.

The adhesive agent composition may contain a hydrocarbon resin for the purpose of improving workability, sticking properties, etc. The hydrocarbon resin may be any of natural resins and synthetic resins. As the natural resins, rosin, a rosin derivative, and a terpen-based resin are preferably used. Practicable examples of the rosin include a gum-based resin, a tall oil-based resin, and a woody resin. Practicable examples of the rosin derivative are obtained by hydrogenating, de-homogenizing, polymerizing, esterifying, or metal-chloridizing the rosin. The terpen resin may be any of terpen-based resins such as α-pinene and β-pinene, or a terpen phenol resin. Other examples of the natural resins include dammar, copal, and shellac. As the synthetic resins, petroleum-based resins, phenol-based resins, and xylene-based resins are preferably used. Practicable examples of the petroleum-based resins include aliphatic petroleum resins, aromatic petroleum resins, alicyclic petroleum resins, copolymeric petroleum resins, hydrogenated petroleum resins, pure monomeric petroleum resins, and a coumarone-indene resin. Practicable examples of the phenol-based resins include an alkylphenol resin and a modified phenol resin. Practicable examples of the xylene-based resins include a xylene resin and a modified xylene resin.

The amount of the added hydrocarbon resin is preferably 1 - 200 weight parts, more preferably 1 - 100 weight parts, with respect to 100 weight parts of the polyester unsaturated compound.

The adhesive agent composition may contain an antiaging agent, an ultraviolet absorber, a dye, a working aid, etc.

The adhesive agent composition preferably has flowability of not larger than 1000 Pa·s, particularly in the range of 50 - 800 Pa·s, in terms of viscosity at the reaction start temperature when shearing viscoelasticity is measured by using parallel plates.

The adhesive film is preferably produced through the steps of kneading the adhesive agent composition by an extruder, rolls, etc., and then forming it into a film with a predetermined shape by a film formation method utilizing a calender roll, T-die extrusion, or inflation. The adhesive film may also be formed through the steps of dissolving or dispersing the adhesive agent composition in a solvent, coating the solution over the surface of a separator, and evaporating the solvent. The film may be embossed, for example, in order to prevent blocking and to facilitate press-bonding to a bonding target.

The adhesive film can be stuck to the bonding target by a sticking method using a heat press, a direct lamination method using an extruder or a calender, a thermal press bonding method using a film laminator.

The bonding can also be performed through the steps of uniformly dissolving various component ingredients in a solvent, uniformly coating the solution over the surface of a separator, temporarily press-bonding other bonding target (such as polyimide or a copper foil) to the coated solution, and thermally hardening it.

Usually, the adhesive agent is hardened preferably at 70 - 170°C, more preferably at 70 - 150°C, for a period of preferably 10 seconds - 120 minutes, more preferably 20 seconds - 60 minutes.

A pressing force applied in the bonding step is preferably 1 - 4 MPa, more preferably 2 - 3 MPa.

When the adhesive film contains conductive particles, film conductivity is preferably not larger than 10 Ω, more preferably not larger than 5 Ω, in the direction of film thickness, and film resistance in the plane direction is preferably not smaller than 10⁶ Ω, more preferably not smaller than 10⁹ Ω.

The adhesive film formed from the adhesive agent composition is used to connect various kinds of terminals to each other, for example, when an FPC board or a TAB chip is connected to ITO terminals formed on a glass substrate of a liquid crystal panel, and when metal electrodes on FPC boards are connected to each other.

The adhesive agent composition may contain conductive particles. The conductive particles may be, for example, powder of a metal or an alloy including copper, silver, nickel, etc., or resin or ceramic powder coated with such a metal or alloy. The particles may have any desired shape including scale-like, dendritic, granular, and pellet-like shapes.

The conductive particles preferably have the elastic modulus of 1.0 × 10⁷ - 1.0 × 10¹⁰ Pa. The adhesive film containing the conductive particles, which has the elastic modulus in such a range, is able to suppress springback after the bonding. The conductive particles are preferably formed of synthetic resin particles of which surfaces are coated with the above-mentioned metal or alloy.

The amount of the mixed conductive particles is preferably 0.1 - 15 volume% of the adhesive agent composition. The average particle size of the conductive particles is preferably 0.1 - 100 µm.

### [Examples According to First and Second Aspects and Comparative Examples]

### Examples 1, 2 and Comparative Examples 1, 2

### (Examples of Bonding Using Non-Conductive Films)

Polyester resins shown in Table 1 were each dissolved in a mixed solvent of toluene and methyl ethyl ketone to prepare a solution of 40 weight%. Other ingredients shown in Table 1 were mixed in amounts, shown in Table 1, with respect to 100 weight parts of each polyester resin. The mixture was coated over a separator made of ethylene polyterephthalate by using a bar coater, whereby a film with a width of 2 mm and a thickness of 20 µm was obtained.

The obtained film was disposed between a 2-layered flexible printed circuit board of.non-adhesive type and a transparent electrode glass, and after peeling off the separator, the film was properly positioned by using a monitor. Then, the substrate and the glass were subjected to thermal press bonding at 130°C and 2 MPa for 30 seconds, whereby a sample was obtained.

The obtained sample was measured for an adhesion force by a 90°-peeling test (50 mm/min) using a tensile tester and was also measured for connection resistance by a digital multi-meter. The measured results are shown in Table 1.

The adhesive agent composition used in the adhesive film was measured for viscosity at the reaction start temperature by measuring shearing viscoelasticity with parallel plates (using ThermoHakke RheoStress 300, frequency: 1 Hz, displacement: 1.0%, temperature rise rate: 6°C/min). The measured results are also shown in Table 1.

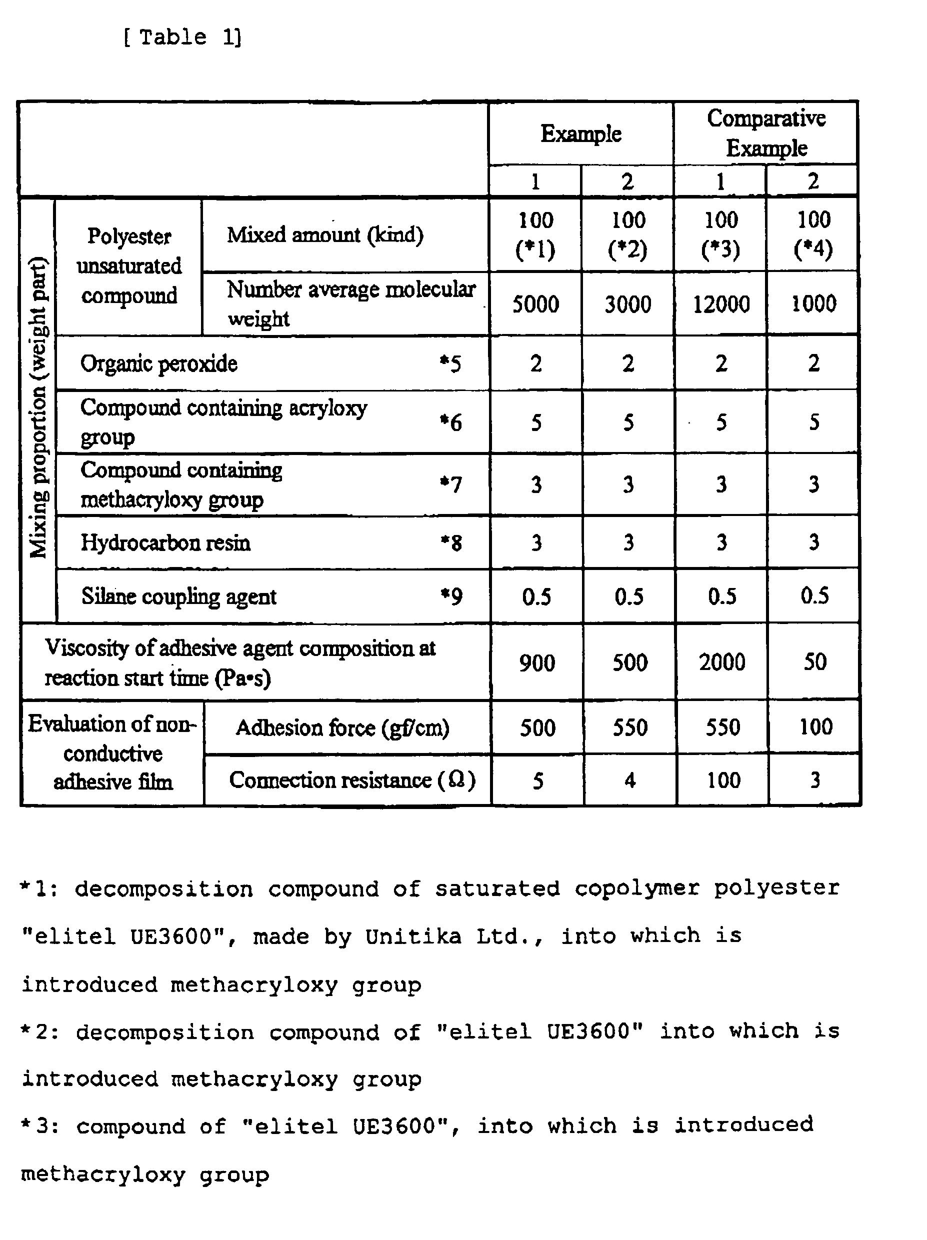

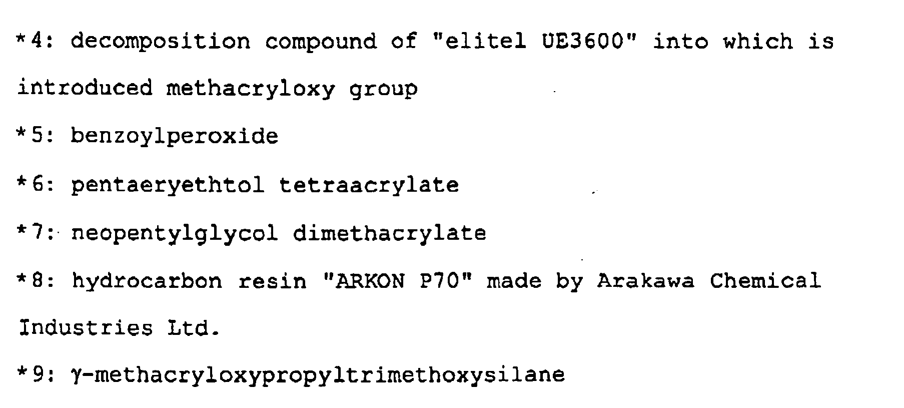

As seen from the results of Table 1, the non-conductive adhesive films each using the polyester unsaturated compound having a number average molecular weight of 2,000 - 6,000 can firmly bond the circuit substrates to each other with good conductivity because of its superior flowability and adhesivity. On the other hand, Comparative Example 1 using a polyester unsaturated compound having a high molecular molecular weight, i.e., a number average molecular weight of 12000, has good adhesivity, but it has poor flowability. Therefore, Comparative Example 1 cannot provide sufficient conductivity. Conversely, Comparative Example 2 using a polyester unsaturated compound having a very low molecular weight, i.e., a number average molecular weight of 1000, has good conductivity, but it has poor adhesivity.

The number average molecular weight was measured by GPC using a polystyrene calibration curve. This point is similarly applied to Examples and Comparative Examples described below.

Examples 3, 4 and Comparative Examples 3, 4

### (Examples of Bonding Using Conductive Films)

Polyester resins shown in Table 2 were each dissolved in a mixed solvent of toluene and methyl ethyl ketone to prepare a solution of 35 weight%. Other ingredients shown in Table 2 were mixed in amounts, shown in Table 2, with respect to 100 weight parts of each polyester resin. The mixture was coated over a separator made of ethylene polyterephthalate by using a bar coater, whereby a film with a width of 2 mm and a thickness of 25 µm was obtained.

The obtained film was disposed between a 3-layered flexible printed circuit board and a transparent electrode glass, and after peeling off the separator, the film was properly positioned by using a monitor. Then, the substrate and the glass were subjected to thermal press bonding at 170°C and 2 MPa for 15 seconds, whereby a sample was obtained.

The obtained sample was measured for an adhesion force by a 90°-peeling test (50 mm/min) using a tensile tester and was also measured for connection resistance by a digital multi-meter. The measured results are shown in Table 2.

The adhesive agent composition used in the adhesive film was measured for viscosity at the reaction start temperature by measuring shearing viscoelasticity with parallel plates (using ThermoHakke RheoStress 300, frequency: 1 Hz, displacement: 1.0%, temperature rise rate: 6°C/min). The measured results are also shown in Table 2.

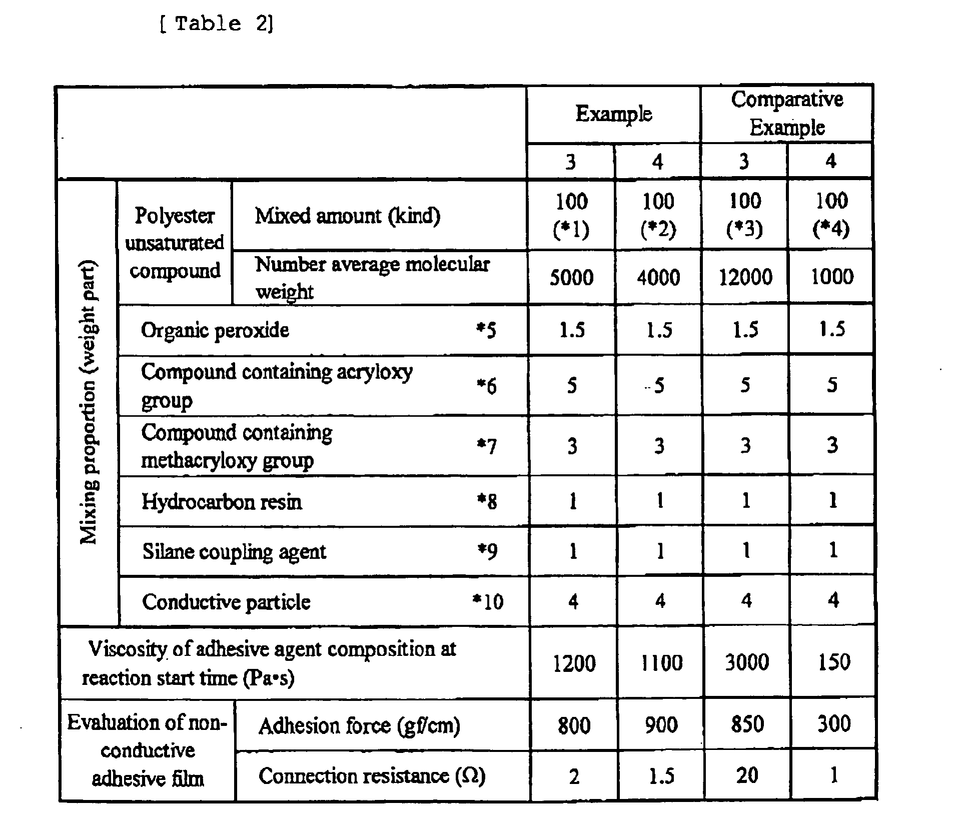

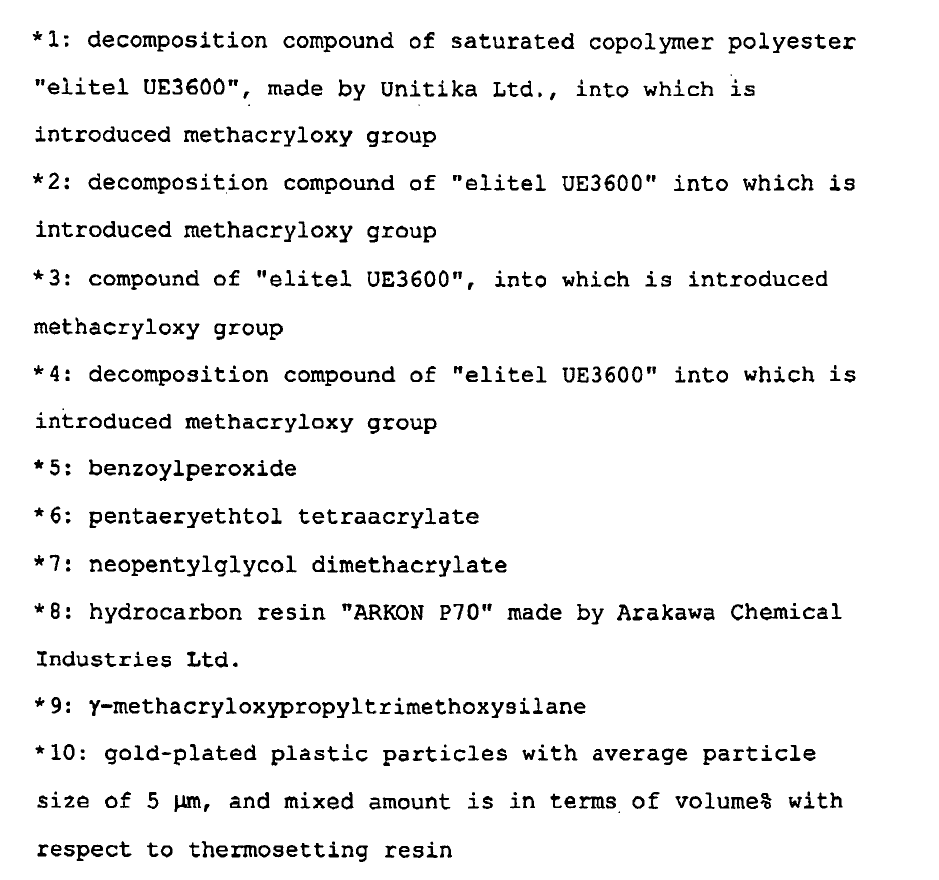

As seen from the results of Table 2, the adhesive film using the polyester unsaturated compound having a number average molecular weight of 2,000 - 6,000 can firmly bond the circuit substrates to each other with good conductivity. On the other hand, Comparative Example 3 using a polyester unsaturated compound having a high molecular molecular weight, i.e., a number average molecular weight of 12000, has good adhesivity, but it has poor flowability. Therefore, Comparative Example 3 cannot provide sufficient contact of the mixed conductive particles with the circuit and eventually cannot provide sufficient conductivity. Conversely, Comparative Example 4 using a polyester unsaturated compound having a very low molecular weight, i.e., a number average molecular weight of 1000, has good conductivity, but it has poor adhesivity.

### Examples 5-8 and Comparative Example 5

### (Examples of Bonding Using Non-Conductive Films)

Polyester resins shown in Table 3 were each dissolved in a mixed solvent of toluene and methyl ethyl ketone to prepare a solution of 40 weight%. Other ingredients shown in Table 3 were mixed in amounts, shown in Table 3, with respect to 100 weight parts of each polyester resin. The mixture was coated over a film of ethylene polyterephthalate, which serves as a separator, by using a bar coater, whereby a film with a width of 2 mm and a thickness of 20 µm was obtained.

After peeling off the separator, the obtained film was properly positioned by using a monitor for bonding between a glass substrate and a polyimide substrate. Then, both the substrates were subjected to thermal press bonding at 170°C and 2 MPa for 15 seconds.

A thus-obtained sample was measured for an adhesion force by a 90°-peeling test (50 mm/min) using a tensile tester immediately after the thermal press bonding (initial), after leaving the sample to stand under an ordinary condition (room temperature) for 24 hours, after leaving the sample to stand under a high-temperature condition (85°C) for 24 hours, and after leaving the sample to stand under a high-temperature and high-humidity condition (60% and 95%RH) for 24 hours. The measured results are shown in Table 3.

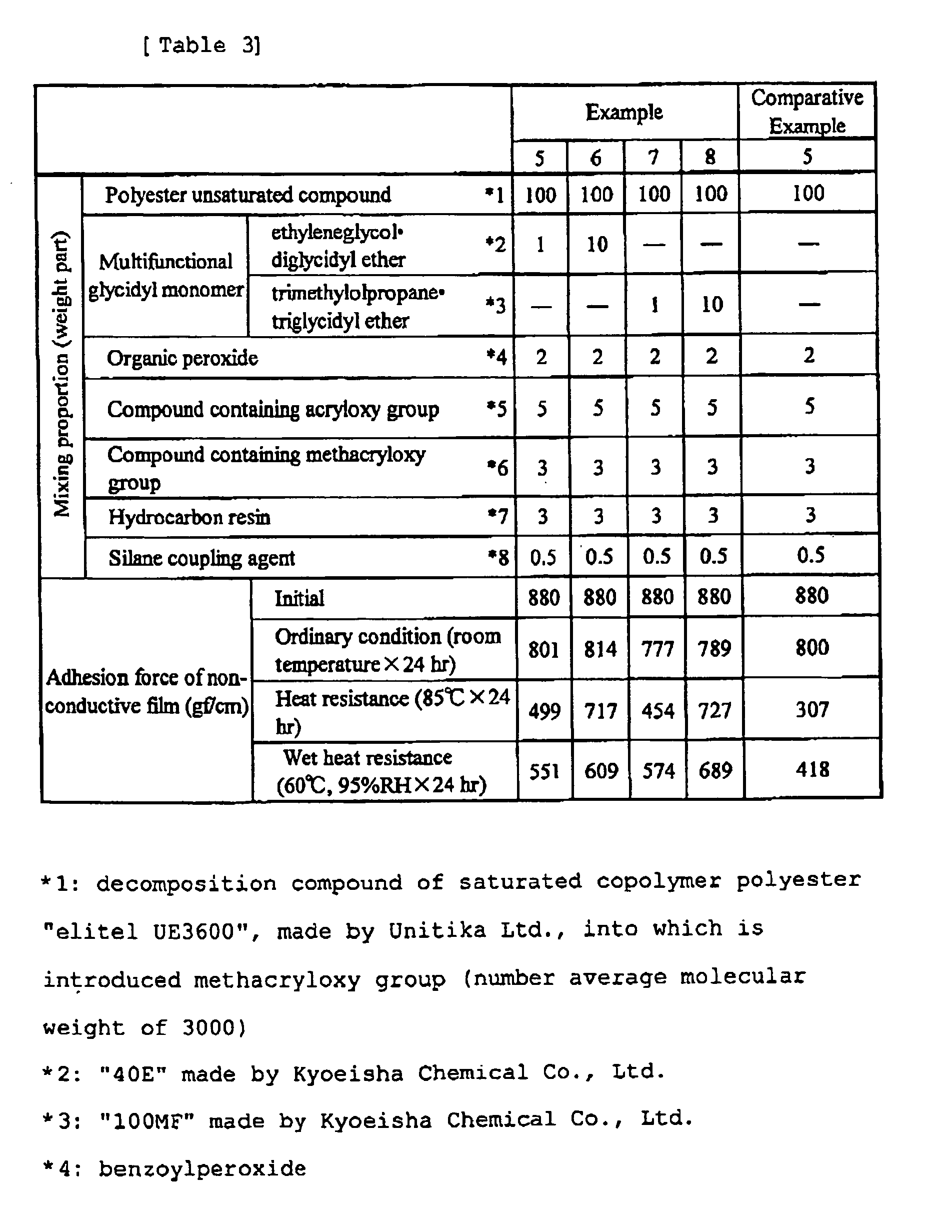

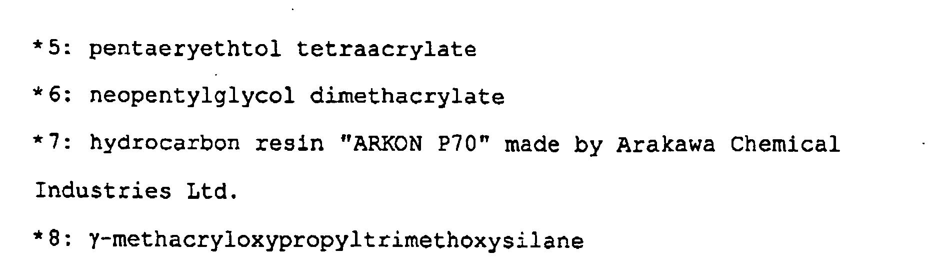

As seen from the results of Table 3, the non-conductive adhesive film using the low-molecular-weight polyester unsaturated compound having a number average molecular weight of 2,000 - 6,000 has no serious problem with durability of an adhesion force at room temperature,
but it has poor durability against heat and against wet heat. On the other hand, the non-conductive adhesive film prepared by mixing the multifunctional glycidyl monomer in the low-molecular-weight polyester unsaturated compound has superior durability of an adhesion force against heat and against wet heat.

### Examples 9-12 and Comparative Example 6

### (Examples of Bonding Using Conductive Films)

Polyester resins shown in Table 4 were each dissolved in a mixed solvent of toluene and methyl ethyl ketone to prepare a solution of 35 weight%. Other ingredients shown in Table 4 were mixed in amounts, shown in Table 1, with respect to 100 weight parts of each polyester resin. The mixture was coated over a film of ethylene polyterephthalate, which serves as a separator, by using a bar coater, whereby a film with a width of 2 mm and a thickness of 30 µm was obtained.

After peeling off the separator, the obtained film was properly positioned by using a monitor for bonding between a two-layered flexible printed circuit board of non-adhesive type and a transparent electrode glass. Then, the board and the glass were subjected to thermal press bonding at 170°C and 2 MPa for 15 seconds.

A thus-obtained sample was measured for an adhesion force by a 90°-peeling test (50 mm/min) using a tensile tester immediately after the thermal press bonding (initial), after leaving the sample to stand under an ordinary condition (room temperature) for 24 hours, after leaving the sample to stand under a high-temperature condition (85°C) for 24 hours, and after leaving the sample to stand under a high-temperature and high-humidity condition (60% and 95%RH) for 24 hours. The measured results are shown in Table 4.

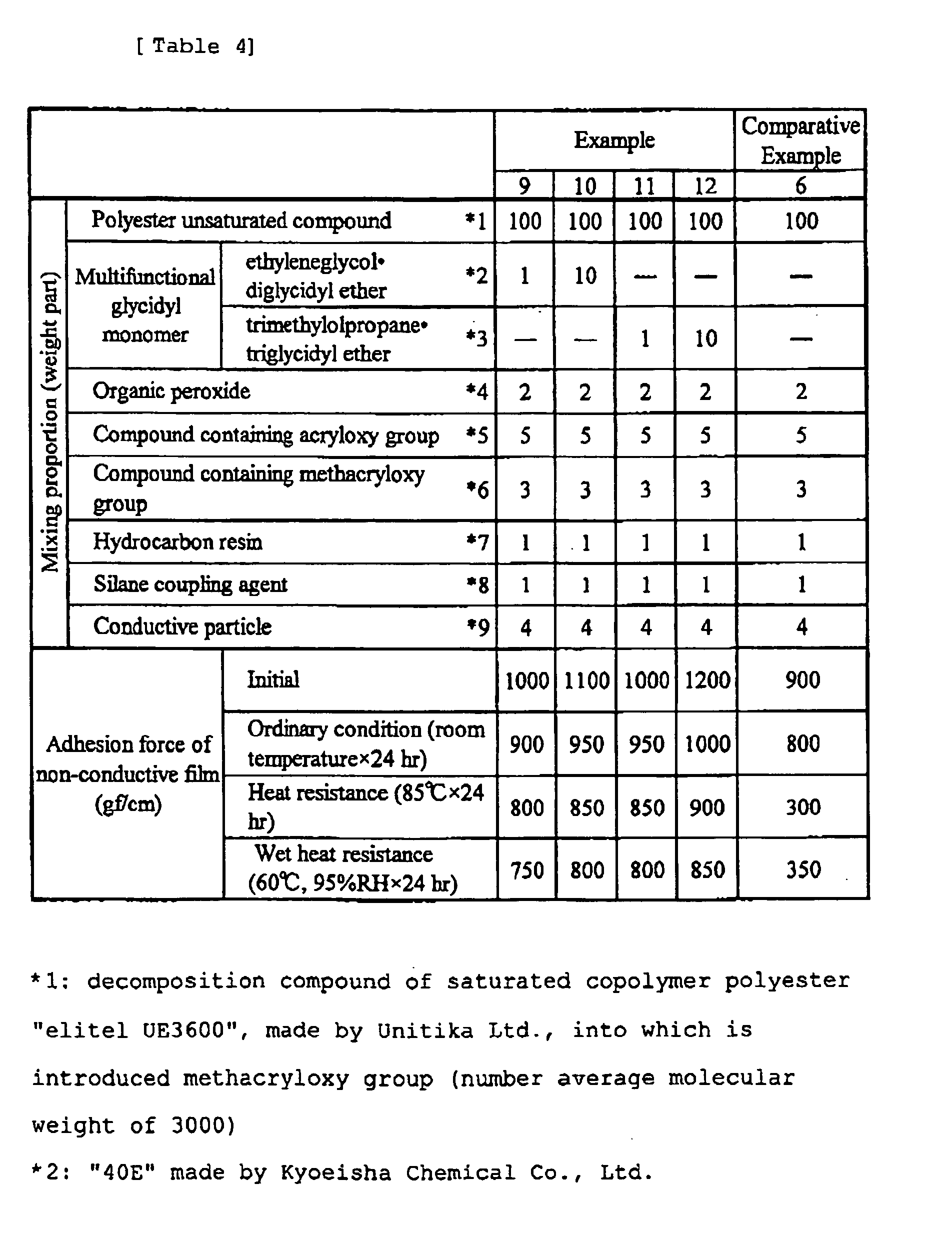

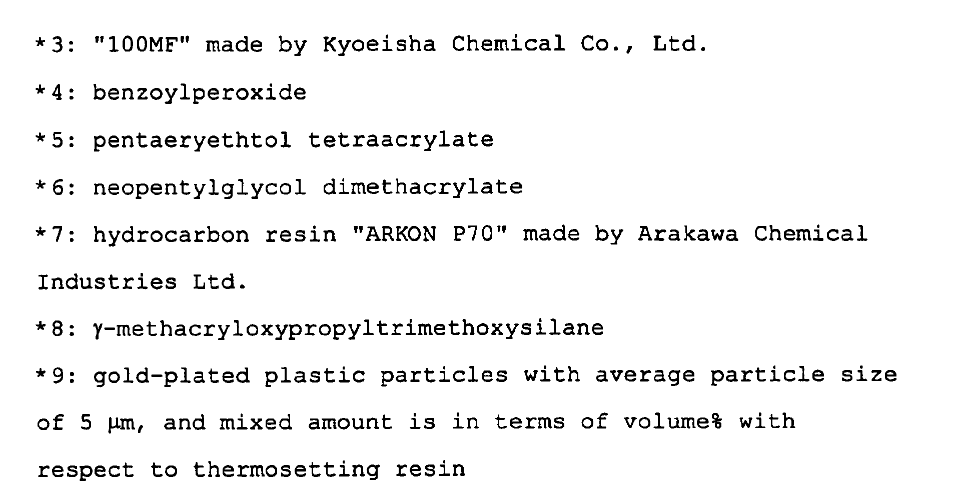

As seen from Table 4, the anisotropic conductive film of Comparative Example 6, which does not contain any multifunctional glycidyl monomer, has no serious problem with durability of an adhesion force at room temperature, but it has poor durability against heat and against wet heat. On the other hand, the films of Examples 9-12, which are mixed with the multifunctional glycidyl monomer, have superior durability of an adhesion force against heat and against wet heat.

## Claims

1. An adhesive agent composition for an electronic component, said adhesive agent composition containing a thermosetting compound and used for bonding said electronic component, wherein:
said thermosetting compound is a polyester unsaturated compound having a number average molecular weight of 2,000 - 6,000;
said polyester unsaturated compound is a compound obtained by introducing an acryloxy group and/or a methacryloxy group into saturated copolymer polyester; and
further containing 0.1 - 10 weight parts of an organic peroxide with respect to 100 weight parts of said thermosetting compound.

2. An adhesive agent composition as claimed in claim 1, further containing a multifunctional glycidyl monomer.

3. An adhesive agent composition as claimed in claim 2, wherein the content of said multifunctional glycidyl monomer is 0.1 - 20 weight parts with respect to 100 weight parts of said polyester unsaturated compound.

4. An adhesive agent composition as claimed in claim 2, wherein said multifunctional glycidyl monomer is a compound belonging to multifunctional glycidyl ethers.

5. An adhesive agent composition as claimed in claim 3, wherein said multifunctional glycidyl monomer is ethyleneglycol diglycidyl ether and/or trimethylolpropane triglycidyl ether.

6. An adhesive agent composition as claimed in claim 1, further containing 0.5 - 80 weight parts of at least one kind of a reactive compound, which is selected from among a group consisting of a compound containing an acryloxy group, a compound containing a methacryoxy group, and a compound containing an epoxy group, with respect to 100 weight parts of said adhesive agent resin component.

7. An adhesive agent composition as claimed in claim 1, further containing 0.01 - 5 weight parts of a silane coupling agent with respect to 100 weight parts of said adhesive agent resin component.

8. An adhesive agent composition as claimed in claim 1, further containing 1 - 200 weight parts of a hydrocarbon resin with respect to 100 weight parts of said adhesive agent resin component.

9. An adhesive agent composition as claimed in claim 1, further containing conductive particles.

10. An adhesive agent composition as claimed in claim 9, wherein said conductive particles are mixed in amount of 0.1 - 15 volume% with respect to said adhesive agent resin component.

11. An electronic component adhesive film for bonding an electronic component, wherein said adhesive film is produced by forming the adhesive agent composition according to claim 1 into a film.

12. Use of the adhesive film according to claim 11, wherein an electronic component is bonded by using said film.

## Patentansprüche

1. Klebmittelzusammensetzung für ein elektronisches Bauelement, wobei die Klebmittelzusammensetzung eine Duroplastverbindung enthält und zum Bondieren des elektronischen Bauelements verwendet wird, wobei:
die Duroplastverbindung eine ungesättigte Polyesterverbindung ist, die ein zahlendurchschnittliches Molekulargewicht von 2.000 - 6.000 aufweist;
die ungesättigte Polyesterverbindung eine Verbindung ist, die durch Einführen einer Acryloxygruppe und/oder einer Methacryloxygruppe in ein ungesättigtes Polyestercopolymer erhalten wird; und
des Weiteren 0,1 bis 10 Gewichtsteile eines organischen Peroxids, auf 100 Gewichtsteile der Duroplastverbindung bezogen, enthaltend.

2. Klebmittelzusammensetzung nach Anspruch 1, des Weiteren ein multifunktionelles Glycidylmonomer enthaltend.

3. Klebmittelzusammensetzung nach Anspruch 2, wobei der Gehalt des multifunktionellen Glycidylmonomers 0,1 - 20 Gewichtsteile, auf 100 Gewichtsteile der ungesättigten Polyesterverbindung bezogen, beträgt.

4. Klebmittelzusammensetzung nach Anspruch 2, wobei das multifunktionelle Glycidylmonomer eine Verbindung ist, die zu multifunktionellen Glycidylethern gehört.

5. Klebmittelzusammensetzung nach Anspruch 3, wobei das multifunktionelle Glycidylmonomer Ethylenglykoldiglycidylether und/oder Trimethylolpropantriglycidylether ist.

6. Klebmittelzusammensetzung nach Anspruch 1, des Weiteren 0,5 - 80 Gewichtsteile mindestens einer Art reaktiver Verbindung enthaltend, die aus einer Gruppe ausgewählt ist bestehend aus einer Verbindung, die eine Acryloxygruppe enthält, einer Verbindung, die eine Methacryloxygruppe enthält. und einer Verbindung, die eine Epoxygruppe enthält, auf 100 Gewichtsteile der Klebmittelharzkomponente bezogen.

7. Klebmittelzusammensetzung nach Anspruch 1, des Weiteren 0,01 - 5 Gewichtsteile eines Silankopplungsmittels, auf 100 Gewichtsteile der Klebmittelharzkomponente bezogen, enthaltend

8. Klebmittelzusammensetzung nach Anspruch 1, des Weiteren 1 - 200 Gewichtsteile eines Kohlenwasserstoffharzes, auf 100 Gewichtsteile der Klebmittelharzkomponente bezogen, enthaltend.

9. Klebmittelzusammensetzung nach Anspruch 1, des Weiteren leitfähige Teilchen enthalten.

10. Klebmittelzusammensetzung nach Anspruch 9, wobei die leitfähigen Teilchen in einer Menge von 0,1 - 15 Volumen-%, auf die Klebmittelharzkomponente bezogen, gemischt sind.

11. Klebfilm für elektronisches Bauelement zum Bondieren eines elektronischen Bauelements, wobei der Klebfilm durch Bilden der Klebmittelzusammensetzung nach Anspruch 1 zu einem Film hergestellt wird.

12. Verwendung des Klebfilms nach Anspruch 11, wobei ein elektronisches Bauelement durch Verwenden des Films bondiert wird.

## Revendications

1. Composition d'agent adhésif pour un composant électronique, ladite composition d'agent adhésif contenant un composé thermodurcissable et elle est utilisée pour coller ledit composant électronique, dans laquelle:
ledit composé thermodurcissable est un composé insaturé de polyester possédant un poids moléculaire moyen en nombre de 2.000-6.000;
ledit composé insaturé de polyester est un composé obtenu en introduisant un groupe acryloxy et/ou un groupe méthacryloxy dans un polyester de copolymère saturé; et
contenant en outre 0,1-10 parties en poids d'un peroxyde organique par rapport aux 100 parties en poids dudit composé thermodurcissable.

2. Composition d'agent adhésif selon la revendication 1, contenant en outre un monomère de glycidyle multifonctionnel.

3. Composition d'agent adhésif selon la revendication 2, dans laquelle la teneur en ledit monomère de glycidyle multifonctionnel est de 0,1-20 parties en poids par rapport aux 100 parties en poids dudit composé insaturé de polyester.

4. Composition d'agent adhésif selon la revendication 2, dans laquelle ledit monomère de glycidyle multifonctionnel est un composé appartenant aux éthers de glycidyles multifonctionnels.

5. Composition d'agent adhésif selon la revendication 3, dans laquelle ledit monomère de glycidyle multifonctionnel est le diglycidyléther d'éthylèneglycol et/ou le triglycidyléther de triméthylolpropane.

6. Composition d'agent adhésif selon la revendication 1, contenant en outre 0,5-80 parties en poids d'au moins un type d'un composé réactif, qui est choisi parmi un groupe constitué d'un composé contenant un groupe acryloxy, d'un composé contenant un groupe méthacryloxy et d'un composé contenant un groupe époxy, par rapport aux 100 parties en poids dudit composant de résine d'agent adhésif.

7. Composition d'agent adhésif selon la revendication 1, contenant en outre 0,01-5 parties en poids d'un agent de couplage de silane par rapport aux 100 parties en poids dudit composant de résine d'agent adhésif.

8. Composition d'agent adhésif selon la revendication 1, contenant en outre 1-200 parties en poids d'une résine hydrocarbure par rapport aux 100 parties en poids dudit composant de résine d'agent adhésif.

9. Composition d'agent adhésif selon la revendication 1, contenant en outre des particules conductrices.

10. Composition d'agent adhésif selon la revendication 9, dans laquelle lesdites particules conductrices sont mélangées dans une quantité de 0,1-15% en volume par rapport audit composant de résine d'agent adhésif.

11. Pellicule adhésive pour composant électronique pour coller un composant électronique, où ladite pellicule adhésive est produite en transformant la composition d'agent adhésif selon la revendication 1 en une pellicule.

12. Utilisation de la pellicule adhésive selon la revendication 11, dans laquelle un composant électronique est collé en utilisant ladite pellicule.
